Europäisches Patentamt

European Patent Office

Office européen des brevets

(11) Numéro de publication: **0 387 163**
**A1**

(12) **DEMANDE DE BREVET EUROPEEN**

(21) Numéro de dépôt: 90420114.2

(22) Date de dépôt: 02.03.90

(51) Int. Cl.⁵: **H01L 27/10, H01L 29/788, H01L 21/82, //G11C17/00**

(30) Priorité: 08.03.89 FR 8903348

(43) Date de publication de la demande:
**12.09.90 Bulletin 90/37**

(84) Etats contractants désignés:
**DE FR GB IT NL**

(71) Demandeur: **SGS-THOMSON MICROELECTRONICS S.A.**
**7, Avenue Galliéni**
**F-94250 Gentilly(FR)**

(72) Inventeur: **Laurens, Michel**
**20, Rue du Fournet**
**F-38120 Saint-Egreve(FR)**

(74) Mandataire: **de Beaumont, Michel**
**1bis, rue Champollion**
**F-38000 Grenoble(FR)**

(54) **Mémoire EPROM de type damier à facteur de couplage élevé et procédé de fabrication.**

(57) La présente invention concerne une mémoire dont les points-mémoire sont constitués de transistors MOS à grille flottante disposés matriciellement en rangées et colonnes. Une première zone d'oxyde épais (12) d'une première épaisseur ($e_1$) recouvre chaque ligne de bit (LB). Une deuxième zone d'oxyde épais (13) d'une deuxième épaisseur ($e_2$) est située entre chaque paire de premières zones d'oxyde épais et entre chaque paire de transistors adjacents d'une même colonne, l'empilement de premier niveau de silicium polycristallin, de couche d'isolement interpoly et de deuxième niveau de silicium polycristallin de chacun des transistors débordant sur chacune des deux deuxièmes zones d'oxyde épais qui l'encadrent.

Fig. 4B

# MEMOIRE EPROM DE TYPE DAMIER A FACTEUR DE COUPLAGE ELEVE ET PROCEDE DE FABRICATION

La présente invention concerne les mémoires à semiconducteurs, et plus particulièrement les mémoires non-volatiles électriquement programmables, ou mémoires EPROM, à grilles flottantes.

La demande de brevet français 86/12938 déposée le 16 septembre 1986 présente des structures dites en damier.

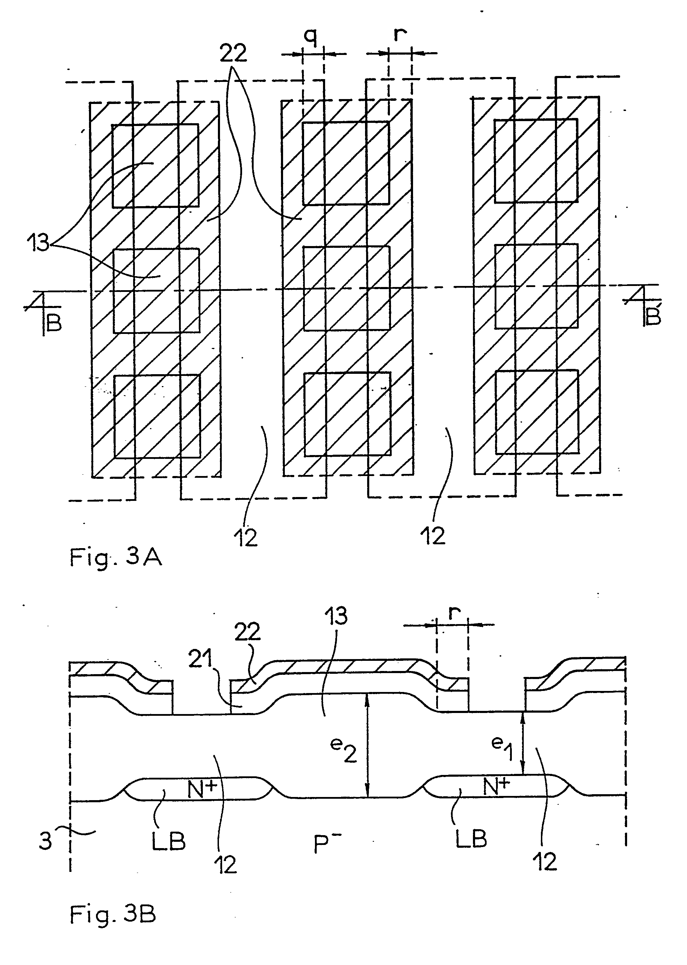

Comme cela peut être retrouvé sur les figures 3, 4 et 5 du document cité, les lignes de mot dans une telle structure en damier sont formées chacune d'un niveau de silicium polycristallin supérieur et les grilles flottantes des transistors d'un niveau de silicium polycristallin inférieur. Les grilles flottantes sont elles-mêmes séparées du substrat par une couche d'oxyde de grille qui a couramment une épaisseur de l'ordre de 20 nm. Cette couche d'oxyde de grille, lors de sa réalisation, est formée sur l'ensemble de la zone mémoire.

Chaque paire de grilles flottantes adjacentes d'une même rangée est séparée par une zone d'isolement qui se prolonge suivant des colonnes. Sous les zones d'isolement se trouvent des diffusions qui sont par exemple de type N$^+$ et qui forment les lignes de bit dans un substrat de type P$^-$.

Ces zones d'isolement, en plus de leur rôle d'isolation électrique, servent couramment à planariser les lignes de mot et elles ont alors une épaisseur de l'ordre de 200 à 300 nm. On trouve ainsi entre les rangées de transistors des régions formées d'une alternance de zones d'oxyde ayant une épaisseur de l'ordre de 20 nm (oxyde de grille) et de zones d'oxyde ayant une épaisseur de l'ordre de 200 à 300 nm (zones d'isolement).

Une étape du procédé de fabrication consiste à graver avec un même masque les niveaux de silicium polycristallin supérieur et inférieur pour justement former les lignes de mot et les grilles flottantes des transistors. Cependant, les moyens d'attaque du silicium polycristallin attaquent également le substrat de silicium et bien qu'ils soient très peu efficaces sur l'oxyde, l'épaisseur de la couche d'oxyde de grille est trop faible pour constituer une barrière à ces moyens d'attaque. Des trous sont ainsi formés dans le substrat entre d'une part les rangées de transistors et entre d'autre part les zones d'isolement qui, elles, sont suffisamment épaisses pour arrêter la gravure. Les trous sont situés entre des paires de diffusions N$^+$ adjacentes formant les lignes de bit et leur présence entraîne une mauvaise isolation entre les diffusions N$^+$ et des risques de claquage.

En outre une étape de fabrication ultérieure, après le dépôt d'une couche d'oxyde intermédiaire, consiste à déposer et graver une couche d'aluminium pour former des bandes sensiblement à l'aplomb des lignes de bit. Ces bandes sont connectées à des lignes de bit d'autres blocs mémoire (en effet, les transistors de mémoires sont habituellement regroupés en blocs occupant un certain nombre de rangées et de colonnes) permettant ainsi d'appliquer le potentiel désiré à ces lignes de bit. Cependant, la couche d'oxyde intermédiaire reproduit sur sa surface supérieure un motif en forme de cuvette à l'emplacement des trous dans le substrat. Chaque cuvette est située entre deux bandes d'aluminium adjacentes. Il se produit alors le fait que la gravure de l'aluminium laisse en place de l'aluminium sur les flancs des cuvettes, cet aluminium résiduel risquant d'établir des courts-circuits entre bandes d'aluminium adjacentes.

La présente invention propose une nouvelle structure en damier permettant de pallier ces inconvénients. La formation de trous dans le substrat est empêchée

Plus précisément, la présente invention prévoit une mémoire dont les points-mémoire sont constitués de transistors MOS à grille flottante disposés matriciellement en rangées et colonnes. Chaque transistor comprend d'une part deux régions du premier type de conductivité qui se prolongent suivant des colonnes pour former des lignes de bit dans un substrat semiconducteur du deuxième type de conductivité et comprend d'autre part entre les deux régions du premier type de conductivité un empilement d'un premier niveau de silicium polycristallin qui constitue la grille flottante, d'une couche d'isolement interpoly et d'un deuxième niveau de silicium polycristallin qui s'étend selon des rangées pour former une ligne de mot. Une première zone d'oxyde épais d'une première épaisseur recouvre chaque ligne de bit. Une deuxième zone d'oxyde épais d'une deuxième épaisseur est située entre chaque paire de premières zones d'oxyde épais et entre chaque paire de transistors adjacents d'une même colonne, l'empilement du premier niveau de silicium polycristallin, de la couche d'isolement interpoly et du deuxième niveau de silicium polycristallin de chacun des transistors débordant sur chacune des deux deuxièmes zones d'oxyde épais qui l'encadrent.

La présente invention prévoit également un procédé de fabrication d'une telle mémoire.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1A représente en vue de dessus une structure à une étape intermédiaire d'un procédé de fabrication selon l'invention et la figure 1B représente une vue en coupe de la figure 1A ;

la figure 2A représente en vue de dessus les limites de zones de la structure à une étape de fabrication ultérieure et la figure 2B représente une vue en coupe de la figure 2A ;

la figure 3A représente en vue de dessus les limites de zones de la structure à une étape de fabrication ultérieure et la figure 3B représente une vue en coupe de la figure 3A ;

la figure 4A représente en vue de dessus les limites de zones de la structure à une étape de fabrication ultérieure et les figures 4B, 4C et 4D représentent différentes vues en coupe de la figure 4A.

De façon générale, comme cela est classique dans la représentation des circuits intégrés, on notera que les diverses figures ne sont pas représentées à l'échelle ni d'une figure à l'autre, ni à l'intérieur d'une même figure, et notamment que les épaisseurs des couches sont dessinées arbitrairement dans le but de faciliter la lecture des figures.

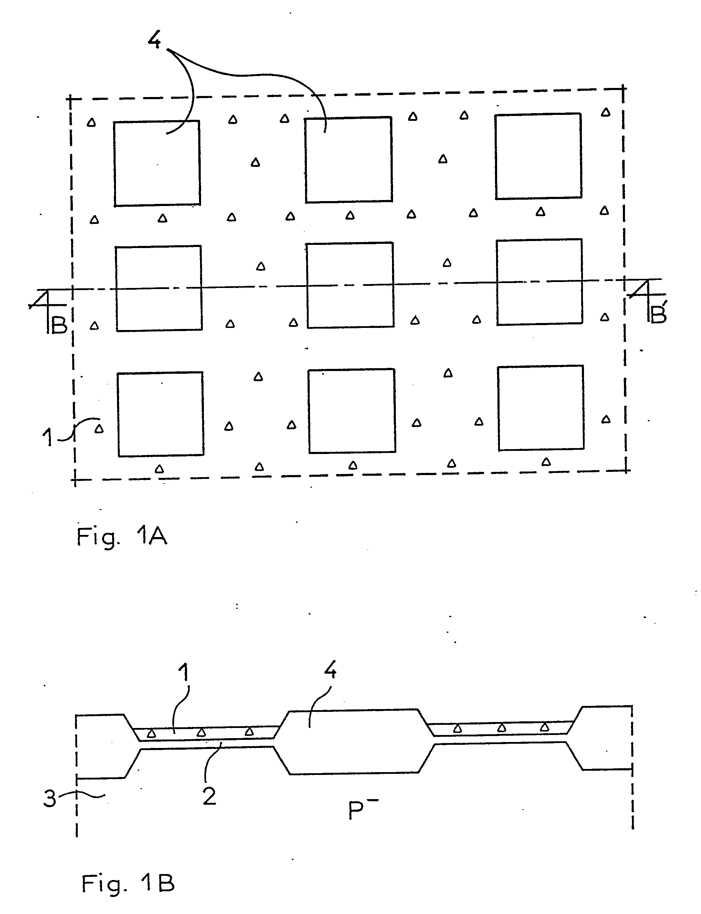

La figure 1A représente en vue de dessus une structure selon l'invention à une étape intermédiaire de fabrication et la figure 1B représente une vue en coupe selon BB' de la figure 1A. Une couche de nitrure de silicium 1 a initialement été déposée sur une couche d'oxyde 2 réalisée sur un substrat 3 de type P⁻. La couche de nitrure de silicium a été partiellement enlevée de telle sorte que des zones sans nitrure sensiblement carrées sont séparées par des intervalles constants selon des rangées et selon des colonnes. Des pavés d'oxyde épais 4, obtenus par oxydation sous traitement thermique, ont été réalisés dans les zones sans nitrure. L'epaisseur de ces pavés est par exemple de l'ordre de 400 nm.

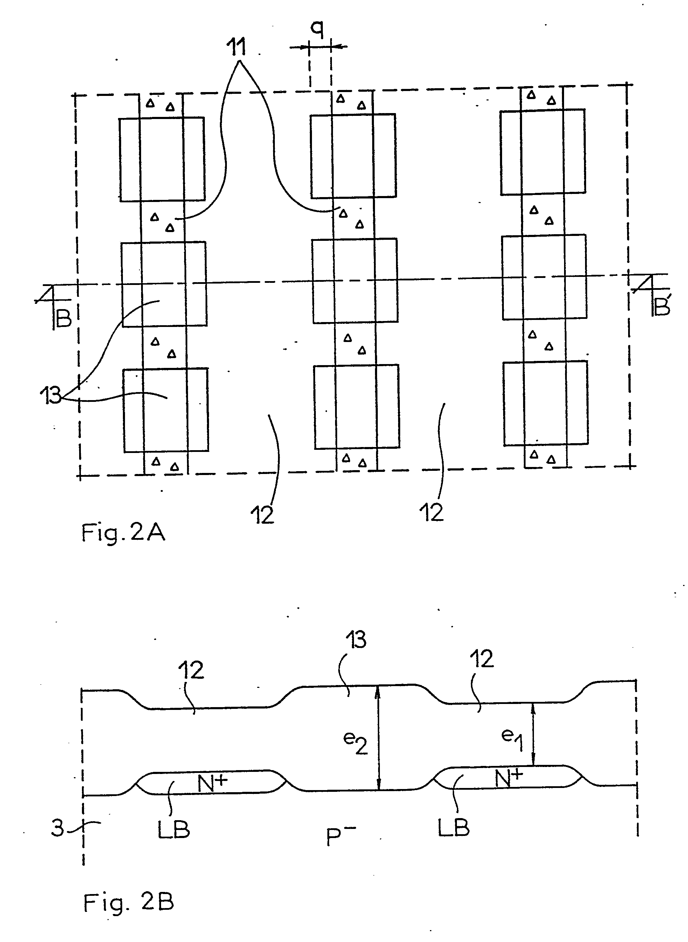

La figure 2A représente en vue de dessus les limites de zones de la structure à une étape de fabrication ultérieure, et la figure 2B une vue en coupe selon BB' de la figure 2A. Une autre partie de la couche de nitrure de silicium a été enlevée pour laisser libres des bandes s'étendant entre chaque paire de colonnes de pavés adjacentes, ces bandes débordant d'une longueur (q) par rapport aux bords des colonnes de pavés Une implantation de type N⁺ a été réalisée au niveau des bandes laissées libres pour former les lignes de bit LB.

Il subsiste à cette étape des zones recouvertes de nitrure de silicium désignées dans la figure 2A par la référence 11. En dehors de ces zones 11, on réalise par oxydation sous traitement thermique ce que l'on appellera des premières zones d'oxyde épais 12 là où il n'existait pas encore d'oxyde épais et des deuxièmes zones d'oxyde épais 13 à l'emplacement des pavés d'oxyde épais. Les premières zones d'oxyde épais 12 sont situées au-dessus des lignes de bit, elles ont une épaisseur $e_1$ de l'ordre de 400 nm Les deuxièmes zones d'oxyde épais 13 ont une épaisseur $e_2$ de l'ordre de 700 nm.

On notera que deux premières zones d'oxyde épais 12 qui encadrent deux deuxièmes zones d'oxyde épais 13 adjacentes d'une même colonne débordent chacune, entre les deux deuxièmes zones d'oxyde épais, d'une longueur (q).

A l'étape des figures 3A et 3B, la figure 3A représentant en vue de dessus les limites de zones de la structure et la figure 3B une vue en coupe selon l'axe BB' de la figure 3A, la totalité du nitrure de silicium a été enlevée et le substrat a été mis à nu dans les zones 11 de la figure 2A. Une couche mince d'oxyde a été réalisée, cette couche faisant office de couche d'oxyde de grille à l'emplacement des zones 11. Un premier niveau de silicium polycristallin et une couche d'isolement ont été déposés et gravés pour former des superpositions de bandes de silicium polycristallin 21 et de bandes d'isolement 22, chaque superposition de bandes recouvrant une colonne de deuxièmes zones d'oxyde épais 13. Les superpositions de bandes débordent par rapport à chacun des bords latéraux des colonnes de deuxièmes zones d'oxyde épais 13 d'une longueur (r).

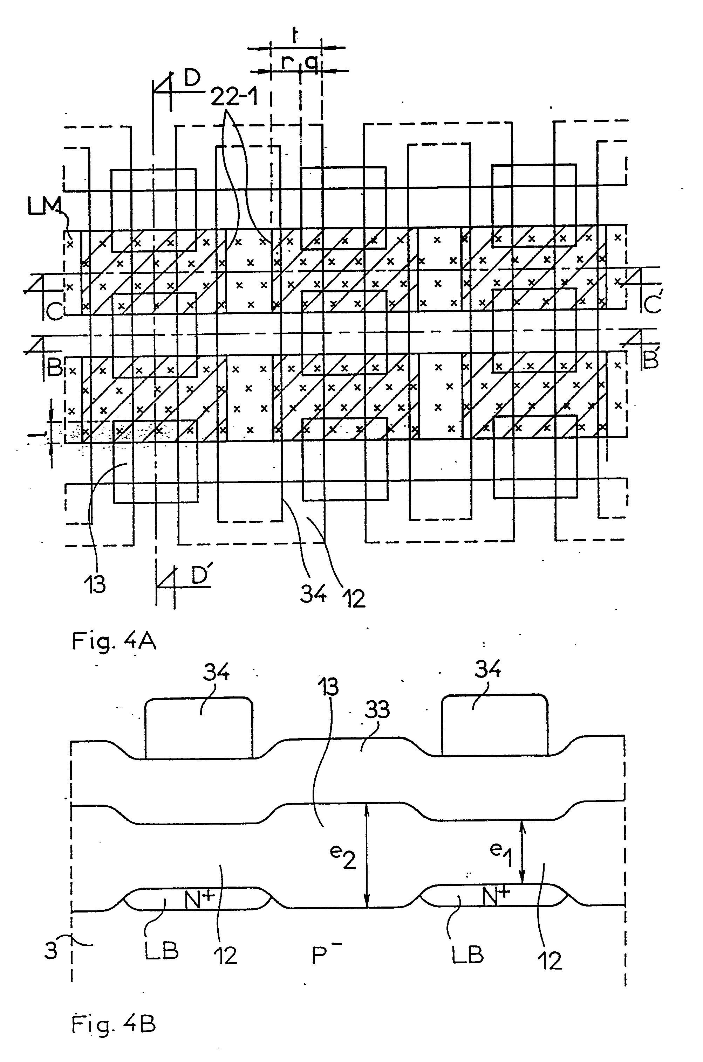

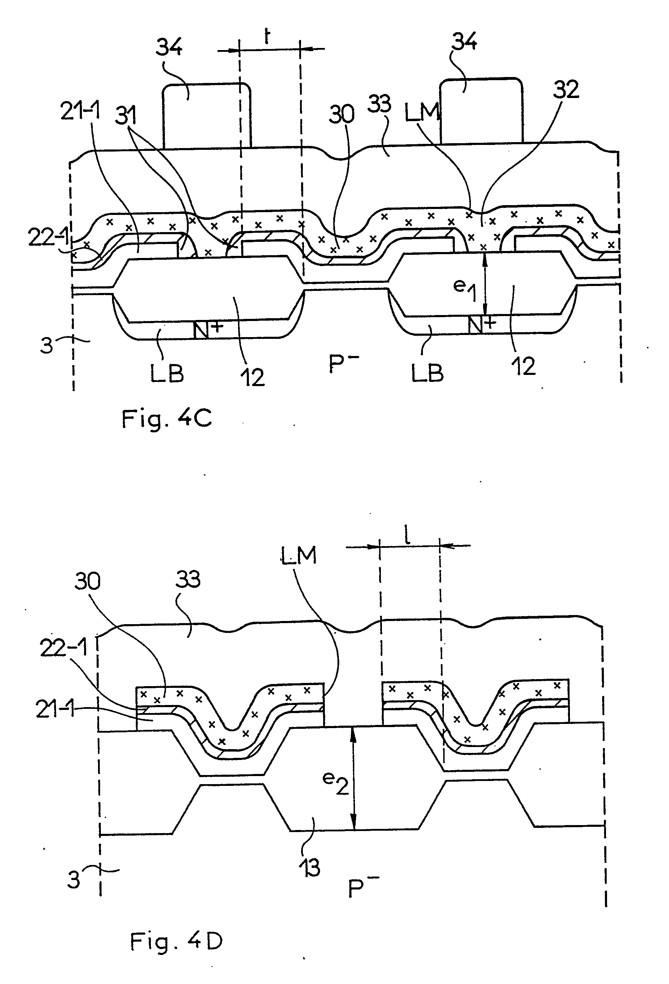

La figure 4A représente en vue de dessus les limites de zones de la structure à une étape ultérieure, les figures 4B, 4C et 4D représentant des vues en coupe selon les axes BB', CC' et DD', respectivement, de la figure 4A. Des zones d'oxyde 31, appelées zones d'oxyde de coin, ont été réalisées sur les régions latérales apparentes des bandes 21 de premier niveau de silicium polycristallin (ces zones d'oxyde de coin apparaissent sur la figure 4C ; elles n'ont pas été représentées sur la figure 4A pour conserver une plus grande clarté de cette figure). Un deuxième niveau de silicium polycristallin a été déposé uniformément. Ce deuxième niveau de silicium polycristallin, les bandes d'isolement 22 et les bandes 21 de premier niveau de silicium polycristallin ont été gravées avec un même masque suivant des rangées pour former entre chaque paire de deuxièmes zones d'oxyde épais 13 adjacentes d'une même colonne un empilement qui comprend une grille flottante 21-1 de premier niveau de silicium polycristallin, une couche d'isolement interpoly 22-1 et une grille de commande 30 de deuxième niveau de silicium polycristallin qui s'étend suivant des rangées pour constituer une ligne de mot LM, l'empilement débordant sur chacune des deux deuxièmes zones d'oxyde épais qui l'encadrent d'une longueur (1).

Comme cela a été indiqué précédemment, deux premières zones d'oxyde épais 12 qui encadrent deux deuxièmes zones d'oxyde épais 13 adjacentes d'une même colonne débordent chacune entre les deux deuxièmes zones d'oxyde épais, d'une longueur (q). En outre, les superpositions de bandes de premier niveau de silicium polycristallin 21 et de bandes d'isolement 22 débordaient par rapport à chacun des bords latéraux des colonnes de deuxièmes zones d'oxyde épais d'une longueur (r). Chaque superposition de grille flottante 21-1 et de couche d'isolement interpoly 22-1 déborde donc sur chacune des deux premières zones d'oxyde épais 12 qui l'encadrent, suivant la direction des rangées, d'une longueur (t) qui est la somme des longueurs (q) et (r).

Une couche d'isolement 33, qui est par exemple une couche d'oxyde, a ensuite été déposée sur l'ensemble du circuit. Une couche conductrice a été déposée et gravée pour former des bandes conductrices 34 sensiblement à l'aplomb des lignes de bit. Ces bandes conductrices sont par exemple des bandes en aluminium. Chaque paire de rangées de transistors adjacentes est séparée par une région comprenant une alternance de premières et deuxièmes zones d'oxyde épais (coupe BB′ de la figure 4A). Lors de la gravure avec un même masque du deuxième niveau de silicium polycristallin, des bandes d'isolement 22 et des bandes 21 de premier niveau de silicium polycristallin, l'attaque est arrêtée sur ces premières et deuxièmes zones d'oxyde épais qui ont une épaisseur suffisante. Il n'y a pas formation de trous dans le substrat. L'isolation entre les lignes de bit n'est ainsi pas affectée. En outre, la surface supérieure de la couche d'oxyde 33 ne présente pas de cuvettes. La gravure de la couche d'aluminium pour former les bandes 34 ne laisse ainsi pas d'aluminium résiduel et les bandes d'aluminium sont totalement isolées les unes des autres.

Selon un aspect de l'invention, le facteur de couplage c qui relie la tension VM appliquée sur la ligne de mot et la tension VF résultante sur la grille flottante d'un transistor par la relation VF = cVM est un facteur de couplage très élevé. En effet, si l'on considère des couches d'oxyde de grille et des couches d'isolement interpoly ayant une même épaisseur, le facteur de couplage est proportionnel à :

$$Si/(Si + Sc)$$

où Si est la surface de la couche d'isolement interpoly et où Sc est la surface de la couche d'oxyde de grille qui sépare la grille flottante du substrat.

Or à l'emplacement d'un transistor, l'empilement comprenant la grille flottante, la couche d'isolement interpoly et la ligne de mot déborde selon la direction des rangées d'une longueur (t) et selon la direction des colonnes d'une longueur (1).

En considérant par exemple une couche d'oxyde de grille carrée ayant des côtés de longueur U et en considérant des débordements t = U et 1 = U/2, le facteur de couplage c devient :

$$c = 6U^2 /(6U^2 + U^2)$$
$$c = 0,86$$

La valeur de U est fonction du photorépéteur utilisé, elle est par exemple égale à 0,6 micromètres

Dans le cas d'une structure de type damier classique, les surfaces Si et Sc sont égales et le facteur de couplage est seulement égal à 0,5.

## Revendications

1. Mémoire dont les points-mémoire sont constitués de transistors MOS à grille flottante disposés matriciellement en rangées et colonnes, chaque transistor comprenant d'une part deux régions du premier type de conductivité qui se prolongent suivant des colonnes pour former des lignes de bit (LB) dans un substrat semiconducteur (3) du deuxième type de conductivité et comprenant d'autre part entre les deux régions du premier type de conductivité un empilement d'un premier niveau de silicium polycristallin qui constitue la grille flottante (21-1), d'une couche d'isolement interpoly (22-1) et d'un deuxième niveau de silicium polycristallin qui s'étend selon des rangées pour former une ligne de mot (LM), une première zone d'oxyde épais (12) d'une première épaisseur ($e_1$) recouvrant chaque ligne de bit, caractérisée en ce qu'une deuxième zone d'oxyde épais (13) d'une deuxième épaisseur ($e_2$) est située entre chaque paire de premières zones d'oxyde épais et entre chaque paire de transistors adjacents d'une même colonne, l'empilement de premier niveau de silicium polycristallin, de couche d'isolement interpoly et de deuxième niveau de silicium polycristallin de chacun des transistors débordant sur chacune des deux deuxièmes zones d'oxyde épais qui l'encadrent

2. Mémoire selon la revendication 1, caractérisée en ce que la deuxième épaisseur ($e_2$) des deuxièmes zones d'oxyde épais (13) est supérieure à la première épaisseur ($e_1$) des premières zones d'oxyde épais (12).

3. Mémoire selon la revendication 1, caractérisée en ce que l'empilement de premier niveau de silicium polycristallin, de couche d'isolement interpoly et de deuxième niveau de silicium polycristallin de chacun des transistors déborde d'une même longueur (1) sur chacune des deux deuxièmes zones d'oxyde épais (13) qui l'encadrent.

4. Mémoire selon la revendication 1, caractérisée en ce que l'empilement de premier niveau de silicium polycristallin, de couche d'isolement interpoly et de deuxième niveau de silicium polycristallin de chacun des transistors déborde d'une longueur (t) sur chacune des deux premières zones d'oxyde épais (12) qui l'encadrent.

5. Mémoire selon la revendication 4, caractérisée en ce que les débordements de l'empilement de premier niveau de silicium polycristallin, de couche d'isolement interpoly et de deuxième niveau de silicium polycristallin sur les premières et deuxièmes zones d'oxyde épais sont choisis de façon à ce que le facteur de couplage soit égal à 0,86.

6. Procédé de fabrication de mémoire de type MOS à transistors à grille flottante disposés selon des rangées et des colonnes sur un substrat (3) d'un premier type de conductivité, caractérisé en ce qu'il comprend les étapes suivantes :

a) réaliser des pavés d'oxyde épais (4) séparés par des intervalles constants selon des rangées et selon des colonnes,

b) réaliser une implantation du deuxième type de conductivité entre chaque paire de colonnes de pavés d'oxyde épais adjacentes pour former des lignes de bit (LB),

c) réaliser, par oxydation sous traitement thermique, des premières zones d'oxyde épais (12) à l'emplacement des lignes de bit et des deuxièmes zones d'oxyde épais (13) à l'emplacement des pavés d'oxyde épais,

d) réaliser sur l'ensemble de la mémoire une couche d'oxyde qui tient lieu de couche d'oxyde de grille à l'emplacement des transistors,

e) déposer uniformément un premier niveau de silicium polycristallin et une première couche d'isolement,

f) graver la première couche d'isolement et le premier niveau de silicium polycristallin pour former des superpositions de bandes de premier niveau de silicium polycristallin (21) et de bandes d'isolement (22) qui recouvrent chacune une colonne de deuxièmes zones d'oxyde épais (13),

g) isoler latéralement (31) les régions apparentes du premier niveau de silicium polycristallin,

h) déposer uniformément un deuxième niveau de silicium polycristallin,

i) graver avec un même masque le deuxième niveau de silicium polycristallin, les bandes d'isolement et les bandes de premier niveau de silicium polycristallin pour former entre chaque paire de deuxièmes zones d'oxyde épais adjacentes d'une même colonne un empilement qui comprend une grille flottante (21-1) de premier niveau de silicium polycristallin, une couche d'isolement interpoly (22-1) et une grille de commande (30) de deuxième niveau de silicium polycristallin qui s'étend suivant des rangées pour constituer une ligne de mot (LM), l'empilement débordant sur chacune des deux deuxièmes zones d'oxyde épais qui l'encadrent,

j) déposer uniformément une deuxième couche d'isolement (33),

k) déposer et graver une couche conductrice pour former des bandes conductrices (34) sensiblement à l'aplomb des lignes de bit, et

l) établir des contacts avec les bandes restantes de deuxième niveau de silicium polycristallin (lignes de mot) et les colonnes de sources et de drains (lignes de bit).

7. Procédé de fabrication de mémoire selon la revendication 6, caractérisé en ce que chacun des empilements de grille flottante (21-1), de couche d'isolement interpoly (22-1) et de grille de commande (30) formés à l'étape (i) déborde sur chacune des deux deuxièmes zones d'oxyde épais (13) qui l'encadrent d'une même longueur (1).

8. Procédé de fabrication de mémoire selon la revendication 6, caractérisé en ce que :
- l'implantation du deuxième type de conductivité est réalisée à l'étape (b) en débordant d'une longueur (q) au-delà des bords latéraux des colonnes de pavés d'oxyde épais (4),
- les premières zones d'oxyde épais (12) débordent également entre chaque paire de deuxièmes zones d'oxyde épais adjacentes d'une même colonne de la longueur (q), et
- les superpositions de bandes de premier niveau de silicium polycristallin (21) et de bandes d'isolement (22) formées à l'étape (f) débordent par rapport à chacun des bords latéraux des colonnes de deuxièmes zones d'oxyde épais (13) d'une longueur (r),
d'où il résulte que chaque superposition de grille flottante (21-1) et de couche d'isolement interpoly (22-1) déborde sur chacune des deux premières zones d'oxyde épais (12) qui l'encadrent d'une longueur (t) égale à la somme des longueurs (q) et (r).

9. Procédé de fabrication de mémoire selon la revendication 6, caractérisé en ce que les premières zones d'oxyde épais (12) ont une première épaisseur (e$_1$) de l'ordre de 400 nm et les deuxièmes zones d'oxyde épais (13) ont une deuxième épaisseur (e$_2$) de l'ordre de 700 nm.

10. Procédé de fabrication de mémoire selon la revendication 6, caractérisé en ce que la couche conductrice déposée à l'étape (k), et ainsi les bandes conductrices obtenues après gravure à cette même étape, sont en aluminium.

Fig. 1A

Fig. 1B

Fig. 2A

Fig. 2B

q    r

22

13

A
B                    A
B

12        12

Fig. 3A

22    13    r
21

e₂    e₁

N⁺    N⁺

3    LB    P⁻    LB

12    12

Fig. 3B

Fig. 4A

Fig. 4B

Fig. 4C

Fig. 4D

Office européen
des brevets

**RAPPORT DE RECHERCHE EUROPEENNE**

Numero de la demande

EP  90 42 0114

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 258 466  (KUO et al.)<br>* En entier *<br>--- | 1-3,6 | H 01 L  27/10<br>H 01 L  29/788<br>H 01 L  21/82  //<br>G 11 C  17/00 |
| A | EP-A-0 109 853  (AMERICAN MICROSYSTEMS, INC.)<br>* Page 11, lignes 4-38; figures 3a-3c *<br>--- | 1 | |
| A | US-A-4 698 900  (ESQUIVEL)<br>* Résumé; figure 1 *<br>----- | 1 | |

DOMAINES TECHNIQUES
RECHERCHES (Int. Cl.5)

H 01 L

Le présent rapport a été établi pour toutes les revendications

| Lieu de la recherche | Date d'achèvement de la recherche | Examinateur |
|---|---|---|
| LA HAYE | 13-06-1990 | BAILLET B.J.R. |